**Europäisches Patentamt**

**European Patent Office**

**Office européen des brevets**

(11) Veröffentlichungsnummer: **0 062 778**

**A1**

## (12) EUROPÄISCHE PATENTANMELDUNG

(21) Anmeldenummer: **82102238.1**

(22) Anmeldetag: **18.03.82**

(51) Int. Cl.³: **C 25 D 3/44**
**H 01 L 21/48**

(30) Priorität: **30.03.81 DE 3112507**

(43) Veröffentlichungstag der Anmeldung:
**20.10.82 Patentblatt 82/42**

(84) Benannte Vertragsstaaten:
**CH DE FR GB LI NL**

(71) Anmelder: **SIEMENS AKTIENGESELLSCHAFT Berlin und München**
**Postfach 22 02 61**
**D-8000 München 22(DE)**

(72) Erfinder: **Birkle, Siegfried, Dr.**
**Veit-Stoss-Strasse 46**
**D-8552 Höchstadt(DE)**

(72) Erfinder: **Stöger, Klaus**
**Beneke Strasse 40**
**D-8500 Nürnberg(DE)**

(54) **Systemträger.**

(57) Die Erfindung betrifft Systemträger, insbesondere für Halbleiter, deren Oberflächen (7) mit einem Galvano-Aluminium, dessen Aluminiumkristalle senkrecht zur Oberfläche des Trägers ausgerichtet sind, beschichtet sind. Die Oberflächenrauhigkeit liegt zwischen 2 und 5 µm bei ca. 5µm Schichtdicke. Zur Abscheidung wird vorzugsweise ein aluminiumorganischer Elektrolyt der Formel $Na[Al_2(C_2H_5)]F \cdot 3$ bis 7 Mol Toluol verwendet und abgeschieden wird bei einer Stromdichte von 2,5 bis 5 A/dm² und 80 bis 95 °C Badtemperatur. Die Systemträger finden vorzugsweise als Kontaktier- und Fixierelemente in der Halbleitertechnik Verwendung.

FIG 1

EP 0 062 778 A1

SIEMENS AKTIENGESELLSCHAFT
Berlin und München

Unser Zeichen
VPA 81 P 7 5 2 6 E

Systemträger

Die Erfindung betrifft Systemträger beschichtet mit Galvano-Aluminium.

Es ist bekannt, Systemträger aus Messing oder Kupfer-Eisen-Legierungen galvanisch zu versilbern oder zu vergolden. Solche Edelmetallbeschichtungen sind teuer. Bei Silberoberflächen sind ferner die Anlaufverfärbungen von Nachteil. Es ist ferner bekannt, die Systemträger mit Aluminium zu bedampfen. Nur im letzteren Fall ist durch Ultraschallschweißen eine Befestigung und Kontaktierung bei elektronischen Bauelementen möglich.

Ferner ist bekannt, elektrisch leitfähige Werkstücke mit einer schützenden Haut von reinem Aluminium zu überziehen. (Elektrotechnik 51, H. 24, Seiten 36 und 37). Es ist auch bereits auf Metallen und leitfähigen Materialien eine haftfeste galvanische Abscheidung eines besonders reinen Aluminiums "Galvano-Aluminium" genannt, möglich. (Bull.ASE 63 (1972) 11, Seiten 596 und 597). In der DE-OS 2 732 687 sind lösbare elektrische Kontakte beschrieben, wobei die Oberfläche der Kontaktteile mit Galvano-Aluminium beschichtet ist.

Das Aufdampfaluminium hat jedoch den gravierenden Nachteil in dickeren Schichten $> 5$ µm nicht mehr haftfest abgeschieden werden zu können. Gerade solche Schichtdicken eignen sich aber gut für die Ultraschallthermokompression. Dünnere Aufdampfaluminiumschichten sind für eine Ultraschallschweißung dieser Art weniger ge-

Wb 2 Gr. / 26.3.1981

geeignet. Die Struktur von Galvano-Aluminium-Beschichtungen bekannter Art erwies sich für viele Kontaktierungen und Fixierungen als nicht hinreichend geeignet.

Aufgabe der Erfindung sind mit Ultraschall leicht anregbare Beschichtungen bei Systemträgern, insbesondere solchen der Halbleitertechnik. Die Schichten sollen insbesondere für die Ultraschallthermokompression geeignet sein.

Diese Aufgabe wird dadurch gelöst, daß gemäß der Erfindung in der Galvano-Aluminium-Beschichtung die Aluminiumkristalle senkrecht zur Oberfläche des Trägers ausgerichtet sind und bei einer Schichtdicke von ca. 5 µm eine Oberflächenrauhigkeit zwischen 2 und 5 µm aufweisen. Die senkrecht aus der Oberfläche austretenden Aluminium-Kristalle sind pyramidenförmig mit nach oben gerichteter Spitze. Die erfindungsgemäßen Beschichtungen zeichnen sich durch besonders gute Verzahnung mit dem zu bondenden Bauelement aus. Auch sind die ausgezeichneten Kontakteigenschaften und die Korrosionsfestigkeit hervorzuheben.

Geeignete zu beschichtende Materialien sind Messing, Tombak, Bronze, Neusilber, Stahl, Eisennickel- und Eisenkupferlegierungen.

Für die Beschichtung geeignete Vorrichtungen sind beispielsweise in der DE-PS 25 37 256 und in der deutschen Patentanmeldung Aktenzeichen P 30 23 827.8 (VPA 80 P 7092), beschrieben.

Die Erfindung betrifft auch ein Verfahren zum Beschichten von Systemträgern. Erfindungsgemäß werden diese in einem aprotischen und sauerstoffreien aluminiumorganischen Elektrolyten der allgemeinen Formel

$M[Al_2(C_2H_5)_6]X$ · n Mol aromat. Kohlenwasserstoff, worin M $Na^+$; $K^+$ oder ein quartäres Oniumion mit N als Zentralatom ist und R Methyl oder Äthyl, X Fluorid oder Chlorid und n eine Zahl zwischen 2 bis 4 bedeuten kann bei einer Stromdichte von 2,5 bis 5 A/dm² und 80 bis 95 °C Badtemperatur galvanisch mit Aluminium beschichtet. Als besonders geeignet hat sich ein aluminiumorganischer Elektrolyt der Formel
$Na[Al_2(C_2H_5)_6]F$ · 3 bis 7 Mol Toluol erwiesen.

Gemäß der Erfindung beschichtete Systemträger sind beispielsweise TO-Böden für Transistoren bzw. DIL-Bänder zur Befestigung von diskreten Halbleitern oder integrierten Schaltkreisen.

Die Erfindung wird anhand der Zeichnung näher erläutert.

In der Zeichnung zeigt:

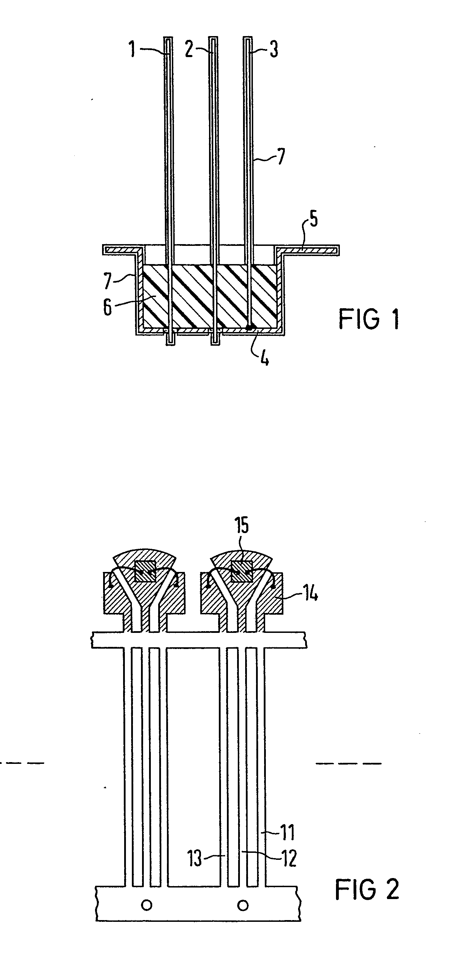

FIG 1 TO-Böden, wobei 1, 2 und 3 die Anschlüsse für den Transistor sind. 3 dient gleichzeitig als Fixierfläche 4. Das Metallgehäuse mit den beiden Durchführungen für die Anschlußdrähte 1 und 2 ist mit 5 bezeichnet. Die Drähte sind in ein Harz 6 eingegossen. Die auf den Anschlüssen 1, 2, 3 und 5 aufgebrachte Galvano-Aluminium-Schicht ist jeweils mit 7 bezeichnet.

FIG 2 zeigt einen Systemträger. Bei diesen dienen die Anschlüsse 11, 12 und 13, die teilweise mit Galvano-Aluminium 14 beschichtet sind einerseits zur Fixierung des Halbleiterbauelements 15 und andererseits zu dessen elektrischer Kontaktierung.

Die Erfindung wird weiterhin durch die folgenden Ausführungsbeispiele näher erläutert.

Beispiel 1:

Bei einer sogenannten TO-Bodenplatte mit 3 Anschlußdrähten, wie sie für die Herstellung von Transistoren verwendet werden, werden die Stirnseiten der Drahtenden - die zur Ultraschall-Schweißung dienen - mit ca. 5 µm Galvano-Aluminium beschichtet.

Hierzu wird der TO-Boden mit seinen Anschlußdrähten so in eine Metallschiene eingeklemmt, daß die Drahtenden für die Ultraschall-Schweißung freibleiben. Danach werden die zu aluminierenden Kontaktflächen - wie in der Galvanik üblich - in verdünnter Säure schwach gebeizt und kathodisch entfettet. Nach dem Spülen in Wasser wird das Teil durch Tauchen in einer Freonentwässerungsanlage entwässert bzw. getrocknet und anschließend in eine Aluminierapparatur gemäß DE-PS 25 37 256 gegeben.

Die darauffolgende galvanische Aluminierung ist durch folgende Kenngrößen charakterisiert:

| | |
|---|---|
| AL-Elektrolyt | $Na[Al_2(C_2H_5)_6]F \cdot 3$ mol Toluol |
| Elektrolyttemperatur | ca. 90 °C |
| Kathoden-Anoden-Abstand | ca. 10 cm; Kathodenbewegung 15 cm/sec. |
| Abscheidungsfrequenz | ca. 10 Hz |
| Taktzeit | 4 : 1 |
| mittlere Stromdichte | ca. 2,5 A/dm² |
| Abscheidungszeit | ca. 10 min |
| Aussehen der Kristalle | pyramidenförmig |

Die mit Aluminium beschichteten Stirnseiten der Drahtenden lassen sich gut bondern.

Beispiel 2:

Bei einem Systemträgerband, bestehend aus Messing, Neusilber oder einer Eisenkupfer-Legierung, wie es zum
Bonden für integrierte Schaltkreise verwendet wird, sind
die Chipauflageflächen und die Anschlußfahnen mit ca. 2 μm
Galvano-Aluminium zu beschichten. Hierbei wird für die
galvanische Aluminierung eine Banddurchlaufzelle verwendet, wie sie in Patentanmeldung Aktenzeichen
P 30 23 827.8 (VPA 80 P 7092) beschrieben ist.

Nach einer in der Galvanik üblichen Vorbehandlung - Beizen,
kathodisches Entfetten - wurde das Band im Geradeausdurchzug zunächst in einer Art Schleusenkammer entwässert
und dann aluminiert.

Die charakteristischen Kenngrößen sind:

| | |
|---|---|
| Al-Elektrolyt | $K[Al_2(C_2H_5)_6]F \cdot 7$ mol Toluol |
| Elektrolyttemperatur | ca. 90 °C |
| Kathoden-Anoden-Abstand | 2 cm |
| Bandgeschwindigkeit | 2 m/min. |
| Elektrolytgeschwindigkeit | ca. 0,5 m/sec. |
| mittlere Stromdichte | ca. 5 A/dm² |
| Expositionszeit | 2 min. |
| Aussehen der Al-Schicht | hellglänzende (?) pyramiden-förmige Kristalle |

3 Patentansprüche
2 Figuren

**Patentansprüche**

1. Systemträger, insbesondere für Halbleiter beschichtet mit Galvano-Aluminium, d a d u r c h   g e k e n n - z e i c h n e t , daß in der Galvano-Aluminium-Beschichtung die Aluminiumkristalle senkrecht zur Oberfläche des Trägers ausgerichtet sind und bei einer Schichtdicke von ca. 5 µm eine Oberflächenrauhigkeit zwischen 2 und 5 µm aufweisen.

2. Verfahren zur Beschichtung von Systemträgern gemäß Anspruch 1, d a d u r c h   g e k e n n z e i c h n e t, daß die Systemträger in einem aprotischen und sauerstoffreien aluminiumorganischen Elektrolyten der allgemeinen Formel $M[Al_2(C_2H_5)_6]X \cdot n$ Mol aromat. Kohlenwasserstoff, worin M $Na^+$; $K^+$ oder ein quartäres Oniumion mit N als Zentralatom ist und R Methyl oder Äthyl, X Fluorid oder Chlorid und n eine Zahl zwischen 2 bis 4 bedeuten kann, bei einer Stromdichte von 2,5 bis $5 \cdot A/dm^2$ und 80 bis 95 °C Badtemperatur galvanisch mit Aluminium beschichtet werden.

3. Verfahren nach Anspruch 2, d a d u r c h   g e - k e n n z e i c h n e t , daß ein aluminiumorganischer Elektrolyt der Formel $Na[Al_2(C_2H_5)_6]F \cdot 3$ bis 7 Mol Toluol verwendet wird.

FIG 1

FIG 2

`0062778`

Europäisches
Patentamt

**EUROPÄISCHER RECHERCHENBERICHT**

Nummer der Anmeldung

EP  82 10 2238

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-4 126 511  (FORD) | | C 25 D    3/44<br>H 01 L   21/48 |
| A | US-A-4 148 204  (DÖTZER)<br>* Spalte 16, Zeilen 10-30 * | 2,3 | |
| A | US-A-3 971 428  (HALL) | | |

---

|  | RECHERCHIERTE SACHGEBIETE (Int. Cl. ³) |
|---|---|
|  | C 25 D<br>H 01 L |

Der vorliegende Recherchenbericht wurde für alle Patentansprüche erstellt.

| Recherchenort<br>DEN HAAG | Abschlußdatum der Recherche<br>12-07-1982 | Prüfer<br>NGUYEN THE NGHIEP |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

 

& : Mitglied der gleichen Patentfamilie, übereinstimmendes Dokument

EPA Form 1503. 03.82